(19) Europäisches Patentamt / European Patent Office / Office européen des brevets

(11) **EP 4 515 258 B1**

(12) **EUROPEAN PATENT SPECIFICATION**

(45) Date of publication and mention
of the grant of the patent:
**03.06.2026 Bulletin 2026/23**

(51) International Patent Classification (IPC):
**B60L 3/04** *(2006.01)* **G01R 31/00** *(2006.01)*
**G01R 31/52** *(2020.01)* **B60L 3/00** *(2019.01)*

(21) Application number: **23724401.7**

(22) Date of filing: **27.04.2023**

(52) Cooperative Patent Classification (CPC):
**G01R 31/006; B60L 3/0069; B60L 3/04;**
**G01R 31/007; G01R 31/52;** B60L 2250/10

(86) International application number:
**PCT/IB2023/054355**

(87) International publication number:
**WO 2023/209623 (02.11.2023 Gazette 2023/44)**

(54) **MONITORING METHOD**

ÜBERWACHUNGSVERFAHREN

PROCÉDÉ DE SURVEILLANCE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **29.04.2022 IT 202200008600**

(43) Date of publication of application:
**05.03.2025 Bulletin 2025/10**

(73) Proprietors:
• **Eldor Corporation S.p.A.**
**22030 Orsenigo (Como) (IT)**
• **Dr. Ing. h.c. F. Porsche AG**
**70435 Stuttgart (DE)**

(72) Inventors:
• **FORTE, Pasquale**
**22030 Orsenigo (Como) (IT)**
• **LISANTI, Paolo**
**22030 Orsenigo (Como) (IT)**
• **DATTILO, Stefano**
**22030 Orsenigo (Como) (IT)**
• **BERTINO, Francesco**
**22030 Orsenigo (Como) (IT)**

(74) Representative: **Grassi, Stefano et al**
**Bugnion S.p.A.**
**Viale Lancetti, 17**
**20158 Milano (IT)**

(56) References cited:
CN-A- 112 505 592      US-A1- 2009 108 850
US-A1- 2020 249 264

• WANG JIN ET AL: "Nonisolated Electric Vehicle
Chargers: Their Current Status and Future
Challenges", IEEE ELECTRIFICATION
MAGAZINE, IEEE, USA, vol. 9, no. 2, 4 June 2021
(2021-06-04), pages 23 - 33, XP011858258, ISSN:
2325-5897, [retrieved on 20210604], DOI: 10.1109/
MELE.2021.3070935

## Description

This invention relates to the technical field of safety procedures.

In particular, this invention relates to a monitoring method advantageously applicable in the automotive field.

This method involves monitoring the possible electrical potential value present between the vehicle frame and the grounding in such a way as to enable a user to be alerted if said value reaches levels and/or characteristics that may present a danger to their health.

This is of particular importance in the case of vehicles with electric traction, which are equipped with one or more battery packs that can be connected to the power grid to accumulate the energy required to provide power for engine operation.

In this context, failures or damage may occur to the devices, cables in particular, used to connect the vehicle to the power grid.

When such an eventuality occurs, a situation may arise in which the vehicle frame is no longer correctly electrically insulated from the circuitry and components that connect the grid to those elements of the vehicle to be powered/charged, and consequently an electrical potential builds up on it in relation to a zero potential ground.

If a user subsequently touches the frame, the circuit between the latter and the earth is then closed and an electric current is discharged through their body with the risk of causing extensive and potentially irreversible harm.

In this context, it is clear how the possibility of monitoring the potential of the vehicle frame, especially when connected to the power grid, is of particular and significant importance, as it allows the user to be immediately alerted to the onset of a potentially dangerous situation.

However, not all power grids have the same characteristics in terms of potentials, frequencies and phases, and even the same grid can be subject to fluctuations in its characteristic values that, however slight, can still have a significant impact on its performance and on the characteristics of the voltage and current supplied.

Therefore, even the monitoring of the voltage potential that could be accumulated on the frame is extremely complex, since to date there are no known methodologies capable of providing, in a manner that is rapid, precise and above all independent of the characteristics of the grid, indications of this potential and information that allow the accurate discrimination of the actual hazardousness of situations that may occur.

In the automotive sector, there is therefore a strong need to develop new solutions capable of providing a mechanism for monitoring potential hazardous situations that may arise when, for whatever reason, a vehicle is connected to a power grid.

An example of technology operating in this field can be found in the article "Nonisolated electric vehicle chargers: their current status and future challenges" by Wang Jin et al. (IEEE ELECTRIFICATION MAGAZINE, vol. 9, no. 2, 4 June 2021, pages 23-33, ISSN: 2325-5897).

In this context, the technical task at the basis of this invention is to propose a monitoring method that overcomes at least some of the drawbacks of the known technique mentioned above.

In particular, one purpose of this invention is to provide a monitoring method capable of quickly, accurately and precisely determining the voltage value on a vehicle frame with respect to an earthing in order to then be able to alert the user of potentially hazardous situations when this voltage value has certain characteristics.

The specified technical task and the specified purposes are achieved with a monitoring method comprising the technical features set forth in the appended claims.

According to this invention, a method for monitoring a voltage value is shown.

In particular, the method described herein can be implemented for monitoring a voltage value on a vehicle frame connected to an electrical grid.

The method is performed by acquiring a first signal representative of a voltage value between a first terminal connected to a first node of the power grid and the vehicle frame.

A second signal representing a voltage value between a second terminal connected to a second node of the power grid and the frame is also acquired.

The first signal is filtered in a filtering band comprising and preferably centred on the grid frequency generating:

- a low frequency component comprising contributions to the first signal in a frequency range below the grid frequency;
- a grid frequency component comprising the contributions to the first signal in a frequency range around the grid frequency;
- a high-frequency component comprising contributions to the first signal in a frequency range above the grid frequency.

The second signal is also filtered, independently of the first signal, in the same manner, generating corresponding components.

In particular, the following are generated:

- a low-frequency component comprising the contributions to the second signal in a frequency range below the grid frequency;
- a grid frequency component comprising the contributions to the second signal in a frequency range around the grid frequency;
- a high-frequency component comprising the contributions to the second signal in a frequency range above the grid frequency.

The low-frequency components, the components at the grid frequency and the high-frequency components are analysed to check whether or not the respective representative values associated with them exceed corresponding predetermined threshold values.

Depending on the result of this verification step, a warning signal is generated.

Advantageously, the procedure outlined here provides a particularly accurate and precise way of assessing the potential between the vehicle frame and an earthing.

This is achieved, in particular, by separating the measured voltage values into components belonging to distinct frequency ranges, whereby the components at the grid frequency (thus influenced by the behaviour of the power grid itself) can be assessed and analysed separately from those at lower and higher frequencies, thus enabling them to be analysed taking into account the specificities of the individual contributions at the various frequencies of interest.

The dependent claims, incorporated herein for reference, correspond to different embodiments of the invention.

Further features and advantages of this invention will become clearer from the indicative, and therefore non-limiting, description of a preferred, but not exclusive, embodiment of a monitoring method, as illustrated in the accompanying drawings in which:

- Figure 1 shows in general terms a circuit diagram of a possible situation for implementing the method in which certain parameters of interest are identified;
- Figure 2 shows a block diagram illustrating the logical structure of the method according to this invention, with particular emphasis on how the signals of interest are processed;
- Figure 3 illustrates the operating logic according to which a warning signal is generated for the user in a particular operation of the method.

As indicated, the method according to this invention makes it possible to monitor a voltage value and therefore the electrical potential (indicated in the figures as the risk potential Vf) accumulated on the frame T of a vehicle with respect to an earthing, when the latter is connected to a power grid E.

Such a situation may occur, for example, if one considers a vehicle with an electrically powered traction that requires for its proper functioning the presence of a battery pack that can be recharged by connecting it via appropriate devices to the power grid E.

If the connection between the power grid E and the vehicle, in particular between the power grid E and vehicle components that need to be powered/recharged, is damaged or defective, a short-circuit may be generated that electrically connects the vehicle frame T with the power grid E.

If the potential accumulated by the frame T were to exceed predetermined limit values, this could pose a danger to anyone coming into contact with the frame T, creating considerable risks to their health.

Operationally, the monitoring is performed by measuring the voltage values present between the terminals that connect the vehicle with the nodes of the power grid E and its frame T, processing them to extract representative values to be compared with appropriate threshold values and generating a warning signal if such a comparison leads to identifying a hazardous situation for the user's health.

In detail, the method is performed by acquiring a first signal $V_{L1}$ representative of a voltage value between a first terminal L1 connected to a first node E1 of the power grid E and the vehicle frame T.

In other words, the first signal $V_{L1}$ identifies the electrical potential established between the vehicle frame T and the terminal L1 through which the vehicle is connected to a first node E1, for example a first phase, of the power grid E.

Similarly, a second signal $V_N$ representing a voltage value between a second terminal N connected to a second node E2 of the power grid E and the frame T is also acquired.

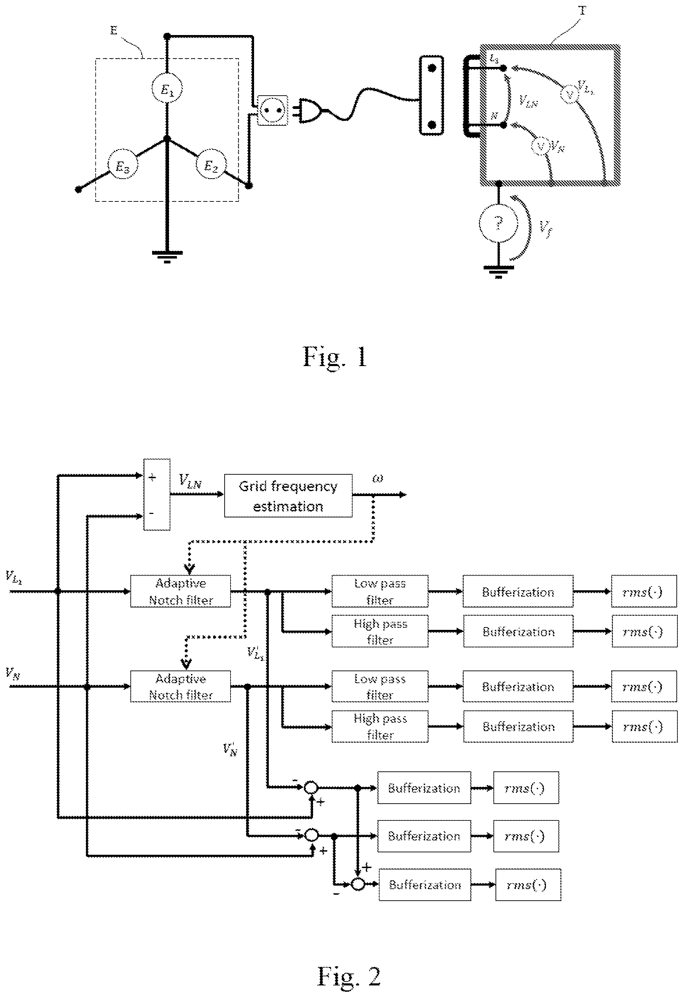

In other words, the second signal $V_N$ identifies the electrical potential established between the vehicle frame T and the terminal N by means of which the vehicle is connected to a second node E2 of the power grid E, in which there may be an additional phase (as illustrated in Figure 1) or even a neutral node with zero potential.

The first and second signal $V_{L1}$, $V_N$ are then frequency filtered independently of each other in such a way that they are divided into respective separate components belonging to contiguous frequency ranges, which will be processed, analysed and evaluated independently of each other.

In more detail, the first signal $V_{L1}$ and the second signal $V_N$ are filtered in a filtering band comprising and preferably centred on the grid frequency $\omega$ of the power grid E.

This specific solution makes it possible to generate a first filtered signal and a second filtered signal each comprising:

- a low frequency component
- a component at the grid frequency w;
- a component at another frequency.

Specifically, the low-frequency component comprises contributions to the first or second signal $V_{L1}$, $V_N$ belonging to a frequency range below the grid frequency $\omega$.

On the other hand, the grid frequency component $\omega$ comprises contributions to the first or second signal $V_{L1}$, $V_N$ belonging to a frequency range around the network frequency $\omega$.

Finally, the high-frequency component comprises the contributions to the first or second signal

$V_{L1}$, $V_N$ belonging to a frequency range above the grid frequency $\omega$.

In other words, the first and second signals $V_{L1}$, $V_N$ are filtered in such a way as to divide and isolate the components of those signals that have a frequency comparable with the grid frequency $\omega$, and that will therefore be affected by the fluctuations and specific characteristics of the operating parameters of the power grid E, with respect to the components that have a lower frequency (identified as low-frequency components) and with respect to the components having a higher frequency (identified as high-frequency components).

Therefore, both the first filtered signal and the second filtered signal comprise three respective components that can be processed and evaluated independently to determine the presence of possible hazardous situations.

This feature is essential because different frequency components can present different degrees of hazardousness to the user's health and, in addition, the component at the grid frequency $\omega$ is influenced by the specific characteristics and behaviour over time of the power grid E and therefore it is advantageous to isolate it and consider it separate from the other components.

These components, i.e. the low-frequency components, the high-frequency components and the components at the grid frequency $\omega$ of the first filtered signal and the second filtered signal are analysed in order to ascertain whether or not a representative value associated with these components exceeds respective predetermined threshold values.

As indicated, components with different frequencies present different degrees of hazardousness, and therefore the division of the first signal $V_{L1}$ and the second signal $V_N$ into separate portions allows each of them to be evaluated according to its specific degree of hazardousness.

This avoids either failing to identify a hazardous situation (because a general threshold has been set that is adequate for some frequencies but is too high for others) or generating unnecessary warning signals when in reality there is no risk for the user (because a general threshold has been set that is adequate for some frequencies but is too low for others).

Therefore, the threshold values associated with the respective components may differ from each other and in particular be lower for those components at frequencies such that even minimal potential values can create risks, and higher for those components at frequencies such that even higher voltage values do not in fact pose any particular risk to the user's health.

If necessary, it is also possible to set different threshold values for the components of the first filtered signal and those of the second filtered signal, or to set the same threshold values for the components of the two separate signals belonging to the same frequency range.

Operationally, the representative values of the low-frequency components and the high-frequency components (i.e. the components that are not influenced by the behaviour of the power grid E) can be directly compared with the respective threshold values.

On the contrary, in order to adequately take into account the possible influence of the power grid E and its characteristics, it is advantageous to evaluate the components at the grid frequency $\omega$ by applying an additional analysis step.

In particular, the analysis of the components at the grid frequency $\omega$ can be performed by generating a differential signal $V_{LN}$ equal to the difference between the component at the grid frequency $\omega$ of the first filtered signal and the component at the grid frequency $\omega$ of the second filtered signal $V_N$.

It is noted that in the case where the second terminal is connected to a neutral node then the differential signal $V_{LN}$ will be substantially equal to the first filtered signal thus allowing a simplification of the analysis procedure outlined below.

This differential signal $V_{LN}$ actually represents the grid frequency component $\omega$ of the voltage between the first and the second terminal L1, N, thus being entirely dependent on the voltage variations of the first and the second node E1, E2 of the power grid E and being at the same time independent from the risk potential $V_f$ e and its variations.

In this specific context, the warning signal is generated if:

- at least one of the representative value associated with the component at grid frequency $\omega$ of the first filtered signal and the representative value associated with the component at the grid frequency $\omega$ of the second filtered signal exceed a respective first threshold value;
- simultaneously the representative value associated with the differential signal $V_{LN}$ is equal to or less than a second threshold value.

If the second terminal is connected to a neutral node, it will be sufficient to monitor only the representative value associated with the component at the grid frequency $\omega$ of the first filtered signal.

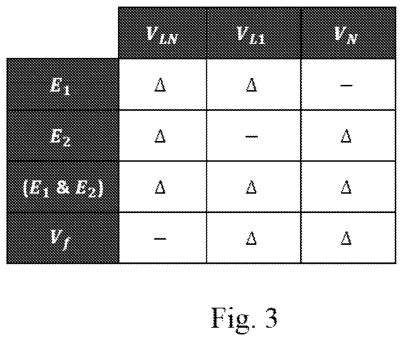

The decision-making process leading to the generation of the warning signal in this context is schematically depicted in Figure 3, where it can be observed how variations in the voltage values of nodes E1 and E2 alone cause a corresponding variation (indicated in the table by the symbol $\Delta$) in the representative values of $V_{LN}$ and $V_{L1}$ and $V_N$ respectively.

Similarly, a simultaneous change in both E1 and E2 causes a change in the representative values of the first signal $V_{L1}$, the second signal $V_N$ and the differential signal $V_{LN}$.

Therefore, variations at nodes E1 and E2 that have no influence on the value of the risk potential $V_f$ also necessarily cause a variation in the value of $V_{LN}$

On the contrary, a variation in the value of the risk potential $V_f$ (and therefore the occurrence of a potential hazardous situation) is identified by variations in the representative values of the first signal $V_{L1}$ or the second signal $V_N$ alone, without any variations in the representative value of the differential signal $V_{LN}$, whose value as defined above is not influenced (and does not influence) the value of the risk potential $V_f$.

It can be seen that in the table shown in Figure 3 there is only one row for evaluating the effects of the variations of the risk potential on the representative values of the signals $V_{L1}$, $V_N$ and $V_{LN}$ because if a situation occurs in which the risk potential $V_f$ varies and at the same time there are no variations (or no significant variations) in the representative value of the differential signal $V_{LN}$ then both the first and the second signal $V_{L1}$, $V_N$ must be changing.

Also in the case in which the second terminal is connected with a neutral node, it can be observed that any variations in the first signal $V_{L1}$ such as to cause a variation in the risk potential $V_f$ also generate a corresponding variation in the second signal $V_N$, since in this context the value of the risk potential $V_f$ would be of equal modulus and the opposite sign with respect to the value of the second signal $V_N$.

Operationally, therefore, when the value of the differential signal $V_{LN}$ does not change, it is sufficient to identify that at least one of the values of the first signal $V_{L1}$ and the second signal $V_N$ exceeds the respective threshold value in order to identify a risk situation.

The procedure outlined above defines a particularly accurate way of identifying risk situations, since the warning signal is only generated when the variations on the first and second signal VL1, VN are actually such as to modify the risk potential $V_f$, avoiding the generation of false alarms when instead such fluctuations are 'absorbed' by the differential signal $V_{LN}$ and do not actually have any impact on the risk potential $V_f$.

From a practical point of view, the value, specifically the representative value, of each component to be taken into consideration for comparison with the respective threshold can be selected as equal to the modulus of the difference between an effective value (root-mean-square, rms) of that component and a respective base value.

In more detail, the base value for the low-frequency and high-frequency components can be set to 0 or alternatively to a predetermined voltage value.

On the other hand, for the grid frequency $\omega$ component, the base value corresponds to an initial effective value of this component, i.e. the effective value calculated at the moment the vehicle is connected to the power grid E.

Operationally, these effective values are evaluated over a predefined time interval that can be selected by varying the specific characteristics of an appropriate buffer.

As illustrated in Figure 2, a respective buffer is applied to each component of each signal, and it is therefore also possible to set different time intervals for the evaluation of the effective values of individual components.

In general, the representative value identifies the variations of the effective value of the component under analysis with respect to its initial/base value, which for the component at the grid frequency $\omega$ is calculated/-determined when the vehicle is connected to the power grid E and when the connection between the two is considered to be correctly functioning.

This representative value can then be expressed using the formula:

$$\Delta Vx,y = |\, \text{rms}\, (V_{x,y\ nominal} - \text{rms}\, (V_{x,y})|$$

wherein:

- $\Delta Vx$ identifies the representative value of the component at the grid frequency $\omega$ relative to the signal x (where x can therefore be L1, N or LN);
- rms ($V_{x\ nominal}$) identifies the base value, i.e. the effective value the component at the grid frequency $\omega$ of the signal x measured when the vehicle is connected to the power grid (E);
- rms ($V_x$) identifies the measured effective value for the component at the grid frequency $\omega$ the signal x.

If the analysis process identified above (which will be explored in greater detail below with reference to specific possible embodiments) leads to the identification of an exceeding of the respective threshold values by the representative values of the components identified for the respective signals, it is possible to generate a warning signal identifying a hazardous situation for the user.

In accordance with a first aspect, such a warning signal is configured to interrupt an electrical power transfer between the vehicle and the power grid E.

In other words, the warning signal is configured to decouple/disconnect the vehicle (hence the frame T) from the power grid E by interrupting the electrical connection present between the two.

Alternatively or additionally, the warning signal is configured to activate an optical signal (e.g. a warning light) and/or acoustic signal capable of promptly alerting the user to the risk situation so that the latter is warned of the need not to make contact with the vehicle frame T.

According to a possible preferred embodiment, the filtering phase of the first and second signals is performed by independently processing the first signal $V_{L1}$ and the second signal $V_N$ by means of a respective band-stop filter (notch filter, preferably of the adaptive type as illustrated in Figure 2), which has a resonance frequency equal to the network frequency $\omega$.

In this manner, a first filtering signal $V'_{L1}$ and a second filtering signal $V'_N$ are generated, and by subtracting these first and second filtering signals $V'_{L1}$, $V'_N$ respectively from the first and second filtering signals

$V_{L1}$, $V_N$, the grid frequency $\omega$ components of the first and second filtered signals are generated.

Also in the specific embodiment just outlined, the low-frequency components can be generated by independently filtering the first filtering signal $V'_{L1}$ and the second filtering signal $V'_N$ by means of a respective low-pass filter.

Similarly, the high-frequency components can be generated by independently filtering the first filtering signal $V'_{L1}$ and the second filtering signal $V'_N$ by means of a high-pass filter.

In other words, the band-stop filter removes from the first and second signal $V_{L1}$, $V_N$ the contribution of the voltages at the grid frequency $\omega$ thus generating respective filtering signals $V'_{L1}$, $V'_N$ that can, in turn, be further divided to separate the low-frequency and high-frequency components that are in no way dependent on the specific behaviour of the power grid E.

These components represent a directly measurable indicator of the value of the hazard potential $V_f$ at low and high frequencies (i.e. for the purposes of this invention at frequencies lower and higher than the grid frequency $\omega$).

In this context, a cut-off frequency of the low-pass filter can be selected equal to a lower cut-off frequency of the band-stop filter and a cut-off frequency of the high-pass filter can be selected equal to a higher cut-off frequency of the band-stop filter.

In this way, the first and second filtered signals are divided into three contiguous frequency ranges and it is possible to ensure that all components contributing to the overall value (and thus contributing to the value of the risk potential $V_f$) are appropriately evaluated.

Alternatively to the above, it is also possible to use a different filtering procedure by implementing one or more filters of a different nature or, in any case, characterised by appropriate and specific transfer functions, as long as they are capable of leading to the separation and discrimination of the components of the filtered signals into the three frequency ranges of interest for the analysis leading to the generation of the warning signal.

Advantageously, the method of this invention may further comprise a step of estimating the grid frequency $\omega$.

In this way, when the vehicle is connected to the power grid E, it is possible to identify the specific grid frequency $\omega$ in such a way that it is possible to accurately set the frequency ranges according to which the division of the first and second signal $V_{L1}$, $V_N$ is to be made.

This step thus makes it possible to make the method that is the subject of this invention easily adaptable to operate on power grids E that have different characteristics.

In detail, the estimation process is carried out by sampling the value of the differential signal $V_{LN}$ with a predefined sampling frequency and dividing this sampling frequency by a counter equal to the number of samplings elapsed between two successive time intervals in which the differential signal $V_{LN}$ has passed from a negative value to a positive value.

In other words, the grid frequency $\omega$ is operationally equal to the frequency of the differential signal $V_{LN}$ and, therefore, by estimating the frequency of the latter using the procedure outlined above, it is possible to identify the grid frequency $\omega$.

Advantageously, this invention achieves the proposed purposes by overcoming the drawbacks complained of in the prior art by providing the user with a monitoring method that enables the detection the occurrence of potential problems and risks related to the accumulation of an electrical potential on the vehicle frame T on any power grid E.

## Claims

1. A method for monitoring a voltage value on a vehicle frame (T) when connected to a power grid (E), said method comprising the steps of:

   - acquiring a first signal ($V_{L1}$) representing a voltage value between a first terminal connected to a first node (E1) of the power grid (E) and the vehicle frame (T);
   - acquiring a second signal ($V_N$) representing a voltage value between a second terminal connected to a second node (E2) of the power grid (E) and the frame (T);
   - independently filtering the first signal ($V_{L1}$) and the second signal ($V_N$) in a filtering band comprising and preferably centred on a grid frequency ($\omega$) of said power grid (E), so as to generate a first filtered signal and a second filtered signal, respectively, each comprising:

      - a low frequency component comprising the contributions to the first or second signals ($V_{L1}$, $V_N$) in a frequency range below the grid frequency ($\omega$);
      - a component at the grid frequency ($\omega$) comprising the contributions to the first or second signal ($V_{L1}$, $V_N$) in a frequency range around the grid frequency ($\omega$);
      - a high frequency component comprising the contributions to the first or second signal ($V_{L1}$, $V_N$) in a frequency range above the grid frequency ($\omega$);

   - analysing the low frequency components, the components at the grid frequency and the high frequency components to check whether a representative value associated with said components exceeds a respective predetermined threshold value;
   - generating a warning signal in the event of a positive check.

**2.** The method according to claim 1, wherein the step of analysing the components at the grid frequency ($\omega$) is performed by generating a differential signal ($V_{LN}$) equal to the difference between the component at the grid frequency ($\omega$) of the first filtered signal and the component at the grid frequency ($\omega$) of the second filtered signal; said warning signal being generated if:

- at least one between the representative value associated with the component at the grid frequency ($\omega$) of the first filtered signal and the representative value associated with the component at the grid frequency ($\omega$) of the second filtered signal exceeds a respective first threshold value; and
- at the same time, the representative value associated with the differential signal ($V_{LN}$) is equal to or less than a second threshold value.

**3.** The method according to claim 1 or 2, wherein the representative value of each component is equal to the modulus of a difference between an effective value of said component and a respective base value.

**4.** The method according to claim 3, wherein each base value for the high frequency component and for the low frequency component is 0 and/or for the component at the grid frequency ($\omega$) corresponds to an initial effective value of said component at the grid frequency ($\omega$), said initial effective value being calculated when the vehicle is connected to the electrical grid (E).

**5.** The method according to any one of the preceding claims, wherein the step of filtering the first and second signals ($V_{L1}$, $V_N$) is performed by independently processing the first signal ($V_{L1}$) and the second signal ($V_N$) by means of a respective band-stop filter having a resonance frequency equal to the grid frequency ($\omega$), so as to generate a first filtering signal ($V'_{L1}$) and a second filtering signal ($V'_N$), respectively, and subtracting said first and second filtering signals ($V'_{L1}$, $V'_N$) from the first and second signals ($V_{L1}$, $V_N$), respectively, generating the components at the grid frequency ($\omega$) of the first and second filtered signals.

**6.** The method according to claim 5, wherein the low frequency components are generated by independently filtering the first filtering signal ($V'_{L1}$) and the second filtering signal ($V'_N$) by means of a low-pass filter.

**7.** The method according to claim 5 or 6, wherein the high frequency components are generated by independently filtering the first filtering signal ($V'_{L1}$) and the second filtering signal ($V'_N$) by means of a high-pass filter.

**8.** The method according to claims 6 and 7, wherein a cut-off frequency of the low-pass filter is equal to a lower cut-off frequency of the band-stop filter, and a cut-off frequency of the high-pass filter is equal to a higher cut-off frequency of the band-stop filter.

**9.** The method according to any one of the preceding claims, wherein the warning signal is configured to suspend a transfer of electrical power between the vehicle and the power grid (E).

**10.** The method according to any one of the preceding claims 2 to 9, comprising a step of assessing the grid frequency ($\omega$), said assessment step being performed by sampling the value of the differential signal ($V_{LN}$) with a predefined sampling frequency and dividing this sampling frequency by a counter equal to the number of samplings between two successive time intervals in which the differential signal ($V_{LN}$) has passed from a negative value to a positive value.

**Patentansprüche**

**1.** Verfahren zum Überwachen eines Spannungswerts an einem Fahrzeugrahmen (T), wenn er mit einem Stromnetz (E) verbunden ist, wobei das Verfahren die folgenden Schritte umfasst:

- Erfassen eines ersten Signals ($V_{L1}$), das einen Spannungswert zwischen einem ersten Anschluss, der mit einem ersten Knoten (E1) des Stromnetzes (E) verbunden ist, und dem Fahrzeugrahmen (T) darstellt;
- Erfassen eines zweiten Signals ($V_N$), das einen Spannungswert zwischen einem zweiten Anschluss, der mit einem zweiten Knoten (E2) des Stromnetzes (E) verbunden ist, und dem Rahmen (T) darstellt;
- unabhängiges Filtern des ersten Signals ($V_{L1}$) und des zweiten Signals ($V_N$) in einem Filterband, das eine Netzfrequenz ($\omega$) des Stromnetzes (E) umfasst und vorzugsweise darauf zentriert ist, um jeweils ein erstes gefiltertes Signal und ein zweites gefiltertes Signal zu erzeugen, die jeweils Folgendes umfassen:

- eine Niederfrequenzkomponente, die die Beiträge zum ersten oder zweiten Signal ($V_{L1}$, $V_N$) in einem Frequenzbereich unterhalb der Netzfrequenz ($\omega$) umfasst;
- eine Komponente bei der Netzfrequenz (w), die die Beiträge zum ersten oder zweiten Signal ($V_{L1}$, $V_N$) in einem Frequenzbereich um die Netzfrequenz ($\omega$) umfasst;

- eine Hochfrequenzkomponente, die die Beiträge zum ersten oder zweiten Signal ($V_{L1}$, $V_N$) in einem Frequenzbereich oberhalb der Netzfrequenz ($\omega$) umfasst;
- Analysieren der Niederfrequenzkomponenten, der Komponenten bei der Netzfrequenz und der Hochfrequenzkomponenten, um zu überprüfen, ob ein repräsentativer Wert, der mit diesen Komponenten assoziiert ist, einen jeweiligen vorbestimmten Schwellenwert überschreitet;
- Erzeugen eines Warnsignals bei positiver Überprüfung.

2. Verfahren nach Anspruch 1, wobei der Schritt zum Analysieren der Komponenten bei der Netzfrequenz ($\omega$) durch Erzeugen eines Differenzsignals ($V_{LN}$) durchgeführt wird, das gleich der Differenz zwischen der Komponente bei der Netzfrequenz ($\omega$) des ersten gefilterten Signals und der Komponente bei der Netzfrequenz ($\omega$) des zweiten gefilterten Signals ist; wobei das Warnsignal erzeugt wird, wenn:

- mindestens einer zwischen dem repräsentativen Wert, der mit der Komponente bei der Netzfrequenz ($\omega$) des ersten gefilterten Signals assoziiert ist, und dem repräsentativen Wert, der mit der Komponente bei der Netzfrequenz ($\omega$) des zweiten gefilterten Signals assoziiert ist, einen jeweiligen ersten Schwellenwert überschreitet; und
- gleichzeitig der mit dem Differenzsignal ($V_{LN}$) assoziierte repräsentative Wert gleich oder kleiner als ein zweiter Schwellenwert ist.

3. Verfahren nach Anspruch 1 oder 2, wobei der repräsentative Wert einer jeden Komponente gleich dem Modul einer Differenz zwischen einem Ist-Wert der Komponente und einem jeweiligen Basiswert ist.

4. Verfahren nach Anspruch 3, wobei ein jeder Basiswert für die Hochfrequenzkomponente und für die Niederfrequenzkomponente 0 ist und/oder für die Komponente bei der Netzfrequenz ($\omega$) einer anfänglichen Ist-Wert der Komponente bei der Netzfrequenz ($\omega$) entspricht, wobei der anfängliche Ist-Wert berechnet wird, wenn das Fahrzeug an das Stromnetz (E) angeschlossen ist.

5. Verfahren nach einem der vorhergehenden Ansprüche, wobei der Schritt zum Filtern des ersten und zweiten Signals ($V_{L1}$, $V_N$) durchgeführt wird, indem das erste Signal ($V_{L1}$) und das zweite Signal ($V_N$) mittels eines jeweiligen Bandsperrfilters mit einer Resonanzfrequenz gleich der Netzfrequenz ($\omega$) unabhängig verarbeitet werden, um ein erstes Filtersignal ($V'_{L1}$) bzw. ein zweites Filtersignal ($V'_N$) zu erzeugen, und das erste und zweite Filtersignal ($V'_{L1}$, $V'_N$) von dem ersten bzw. zweiten Signal ($V_{L1}$, $V_N$) subtrahiert werden, wodurch die Komponenten bei der Netzfrequenz ($\omega$) des ersten und zweiten gefilterten Signals erzeugt werden.

6. Verfahren nach Anspruch 5, wobei die Niederfrequenzkomponenten durch unabhängiges Filtern des ersten Filtersignals ($V'_{L1}$) und des zweiten Filtersignals ($V'_N$) mittels eines Tiefpassfilters erzeugt werden.

7. Verfahren nach Anspruch 5 oder 6, wobei die Hochfrequenzkomponenten durch unabhängiges Filtern des ersten Filtersignals ($V'_{L1}$) und des zweiten Filtersignals ($V'_N$) mittels eines Hochpassfilters erzeugt werden.

8. Verfahren nach den Ansprüchen 6 und 7, wobei eine Grenzfrequenz des Tiefpassfilters gleich einer niedrigeren Grenzfrequenz des Bandsperrfilters ist und eine Grenzfrequenz des Hochpassfilters gleich einer höheren Grenzfrequenz des Bandsperrfilters ist.

9. Verfahren nach einem der vorhergehenden Ansprüche, wobei das Warnsignal dazu ausgelegt ist, eine Übertragung von elektrischer Leistung zwischen dem Fahrzeug und dem Stromnetz (E) auszusetzen.

10. Verfahren nach einem der vorhergehenden Ansprüche 2 bis 9, umfassend einen Schritt zum Schätzen der Netzfrequenz ($\omega$), wobei der Schätzungsschritt durchgeführt wird, indem der Wert des Differenzsignals ($V_{LN}$) mit einer vordefinierten Abtastfrequenz abgetastet wird und diese Abtastfrequenz durch einen Zähler geteilt wird, der gleich der Anzahl von Abtastungen zwischen zwei aufeinanderfolgenden Zeitintervallen ist, in denen das Differenzsignal ($V_{LN}$) von einem negativen Wert zu einem positiven Wert übergegangen ist.

**Revendications**

1. Procédé de surveillance d'une valeur de tension sur un châssis (T) de véhicule lorsque celui-ci est connecté à un réseau électrique (E), ledit procédé comprenant les étapes de :

- acquérir un premier signal ($V_{L1}$) représentant une valeur de tension entre une première borne connectée à un premier nœud (E1) du réseau électrique (E) et le châssis (T) de véhicule ;
- acquérir un second signal ($V_N$) représentant une valeur de tension entre une seconde borne connectée à un second nœud (E2) du réseau électrique (E) et le châssis (T) ;
- filtrer indépendamment le premier signal ($V_{L1}$) et le second signal ($V_N$) dans une bande de filtrage comprenant et de préférence centrée sur une fréquence de réseau (ω) dudit réseau électrique (E), de manière à générer, respectivement, un premier signal filtré et un second signal filtré, chacun comprenant :

- une composante basse fréquence comprenant les contributions au premier ou au second signal ($V_{L1}$, $V_N$) dans une gamme de fréquences inférieure à la fréquence de réseau (ω) ;
- une composante à la fréquence de réseau (ω) comprenant les contributions au premier ou au second signal ($V_{L1}$, $V_N$) dans une gamme de fréquences autour de la fréquence de réseau (ω) ;
- une composante haute fréquence comprenant les contributions au premier ou au second signal ($V_{L1}$, $V_N$) dans une gamme de fréquences supérieure à la fréquence de réseau (ω) ;
- analyser les composantes basse fréquence, les composantes à la fréquence de réseau et les composantes haute fréquence afin de vérifier si une valeur représentative associée auxdites composantes dépasse une valeur seuil prédéterminée respective ;
- générer un signal d'alerte en cas de vérification positive.

2. Procédé selon la revendication 1, dans lequel l'étape consistant à analyser les composantes à la fréquence de réseau (ω) est réalisée en générant un signal différentiel ($V_{LN}$) égal à la différence entre la composante à la fréquence de réseau (ω) du premier signal filtré et la composante à la fréquence de réseau (ω) du second signal filtré ; ledit signal d'alerte étant généré si :

- au moins l'une des valeurs représentatives associées à la composante à la fréquence de réseau (ω) du premier signal filtré et à la composante à la fréquence de réseau (ω) du second signal filtré dépasse une première valeur seuil respective ; et
- dans le même temps, la valeur représentative associée au signal différentiel ($V_{LN}$) est inférieure ou égale à une seconde valeur seuil.

3. Procédé selon la revendication 1 ou 2, dans lequel la valeur représentative de chaque composante est égale au module d'une différence entre une valeur effective de ladite composante et une valeur de base respective.

4. Procédé selon la revendication 3, dans lequel chaque valeur de base pour la composante haute fréquence et pour la composante basse fréquence est 0 et/ou pour la composante à la fréquence de réseau (ω) correspond à une valeur efficace initiale de ladite composante à la fréquence de réseau (ω), ladite valeur efficace initiale étant calculée lorsque le véhicule est connecté au réseau électrique (E).

5. Procédé selon l'une quelconque des revendications précédentes, dans lequel l'étape consistant à filtrer les premier et second signaux ($V_{L1}$, $V_N$) est réalisée en traitant indépendamment le premier signal ($V_{L1}$) et le second signal ($V_N$) au moyen d'un filtre coupe-bande respectif ayant une fréquence de résonance égale à la fréquence de réseau (ω), de manière à générer, respectivement, un premier signal de filtrage ($V'_{L1}$) et un second signal de filtrage ($V'_N$), et en soustrayant lesdits premier et second signaux de filtrage ($V'_{L1}$, $V'_N$), respectivement, des premier et second signaux ($V_{L1}$, $V_N$), générant ainsi les composantes à la fréquence de réseau (ω) des premier et second signaux filtrés.

6. Procédé selon la revendication 5, dans lequel les composantes basse fréquence sont générées en filtrant indépendamment le premier signal de filtrage ($V'_{L1}$) et le second signal de filtrage ($V'_N$) au moyen d'un filtre passe-bas.

7. Procédé selon la revendication 5 ou 6, dans lequel les composantes haute fréquence sont générées en filtrant indépendamment le premier signal de filtrage ($V'_{L1}$) et le second signal de filtrage ($V'_N$) au moyen d'un filtre passe-haut.

8. Procédé selon les revendications 6 et 7, dans lequel une fréquence de coupure du filtre passe-bas est égale à une fréquence de coupure inférieure du filtre coupe-bande, et une fréquence de coupure du filtre passe-haut est égale à une fréquence de coupure supérieure du filtre coupe-bande.

9. Procédé selon l'une quelconque des revendications précédentes, dans lequel le signal d'alerte est configuré pour suspendre un transfert d'énergie électrique entre le véhicule et le réseau électrique (E).

10. Procédé selon l'une quelconque des revendications précédentes 2 à 9, comprenant une étape consistant à évaluer la fréquence de réseau (ω), ladite étape d'évaluation étant réalisée en échantillonnant la valeur du signal différentiel ($V_{LN}$) à une fréquence d'échantillonnage prédéfinie et en divisant cette fréquence d'échantillonnage par un décompte égal au nombre d'échantillons entre deux intervalles de temps successifs au cours desquels le signal différentiel ($V_{LN}$) est passé d'une valeur négative à une valeur positive.

Fig. 1

Fig. 2

|  | $V_{LN}$ | $V_{L1}$ | $V_N$ |
|---|---|---|---|
| $E_1$ | Δ | Δ | — |
| $E_2$ | Δ | — | Δ |
| $(E_1 \& E_2)$ | Δ | Δ | Δ |
| $V_f$ | — | Δ | Δ |

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WANG JIN et al.** Nonisolated electric vehicle chargers: their current status and future challenges. *IEEE ELECTRIFICATION MAGAZINE*, 04 June 2021, vol. 9 (2), ISSN 2325-5897, 23-33